# EUROPEAN PATENT APPLICATION

(11) **EP 4 852 704 A1**
(43) Date of publication of application: **09.12.2026**
(21) Application number: 26180307.6
(22) Date of filing: 21.05.2026
(51) Int. Cl.: H10W 90/00, H10H 29/01, H10H 29/24, H10H 29/85, H10H 29/852, H10K 59/80

(54) **DISPLAY COMPONENT, METHOD FOR MANUFACTURING THE DISPLAY COMPONENT, AND ELECTRONIC DEVICE**

(30) Priority: 30.05.2025 CN 202510725365
(71) Applicant: Nothing Technology Limited, London WC1X 8BH (GB)
(72) Inventor: Chen, Jianwu, Shenzhen, PRC518035 (CN); Kong, Fanxi, Shenzhen, PRC518035 (CN); Xiao, Lujun, Shenzhen, PRC518035 (CN)
(74) Representative: EIP

(57) **Abstract**

The present disclosure provides a display component, method for manufacturing the display component, and electronic device. The display component is applied to an electronic device. The display component comprises a plurality of light emitting units; each of the light emitting units comprises: a circuit substrate comprising a mounting surface; an LED chip disposed on the mounting surface and electrically connected to the circuit substrate; and an encapsulant disposed on the mounting surface, and disposed around the LED chip and covering the LED chip, thereby encapsulating the LED chip on the circuit substrate. Therefore, the display component can achieve a flexible and customizable design of the arrangement of the LED chips. By mounting and fixing the LED chips onto the corresponding circuit substrates, the display component can increase the mounting reliability of the LED chips and avoid risks such as loosening or detachment.

## Description

### TECHNICAL FIELD

The present disclosure relates to the technical field of electronic devices, and in particular, to a display component, a method for manufacturing the display component, and an electronic device.

### BACKGROUND

With continuous technological advancements and social development, electronic devices such as smartphones and tablets have become increasingly popular, and have become indispensable products in people's daily lives and work. Currently, an electronic device on the market mainly achieves dot-matrix screen functionality by providing a light strip composed of multiple LED chips on a back side of the electronic device. However, dot-matrix screen in the related art cannot achieve flexible customized designs. Moreover, the mounting reliability of the LED chips within the dot-matrix screen is poor, posing risks such as loosening or detachment.

### SUMMARY

In view of the above mentioned deficiencies of the related art, an objective of the present disclosure is to provide a display component, a method of manufacturing the display component, and an electronic device having the display component, which can achieve flexible customized designs of an arrangement of LED chips. By mounting and fixing the LED chip to a circuit substrate, the mounting reliability of the LED chip can be increased, and risks such as loosening or detachment can be avoided.

To solve the above at least one technical problem, embodiments of the present disclosure provide a display component for use in an electronic device. The display component includes a plurality of light emitting units. Each of the light emitting units includes:
a circuit substrate including a mounting surface;
an LED chip disposed on the mounting surface and electrically connected to the circuit substrate; and
an encapsulant disposed on the mounting surface, and disposed around the LED chip and covering the LED chip, thereby encapsulating the LED chip on the circuit substrate.

Based on the same inventive concept, embodiments of the present disclosure further provide an electronic device. The electronic device includes a middle frame, a rear cover, and a display component disposed between the middle frame and the rear cover. The display component includes a plurality of light emitting units. Each of the light emitting units includes: a circuit substrate including a mounting surface; an LED chip disposed on the mounting surface and electrically connected to the circuit substrate; and an encapsulant disposed on the mounting surface, and disposed around the LED chip and covering the LED chip, thereby encapsulating the LED chip on the circuit substrate.

Based on the same inventive concept, embodiments of the present disclosure further provide a method of manufacturing a display component, for manufacturing the display component described above. The manufacturing method includes: electrically connecting a plurality of LED chips to a circuit substrate; forming an encapsulant layer on the circuit substrate, the encapsulant layer covering and encapsulating the LED chips onto the circuit substrate; cutting the encapsulant layer to divide the encapsulant layer into a plurality of encapsulants, each of the plurality of encapsulants covering a respective one of the plurality of LED chips, so as to form a plurality of light emitting units; and arranging the plurality of light emitting units in a matrix on a circuit board, and electrically connecting the circuit substrates of the plurality of light emitting units to the circuit board.

In summary, in the display component, the manufacturing method for manufacturing the display component, and the electronic device provided in the embodiments of the present disclosure, the electronic device includes a middle frame, a rear cover, and the above described display component disposed between the middle frame and the rear cover. The display component includes a plurality of light emitting units, each light emitting unit including a circuit substrate, an LED chip, and an encapsulant. The circuit substrate includes a mounting surface. The LED chip is disposed on the mounting surface and electrically connected to the circuit substrate. The encapsulant is disposed on the mounting surface, and disposed around the LED chip and covering the LED chip on the circuit substrate. Therefore, by respectively disposing the plurality of LED chips on their respective corresponding circuit substrates and electrically connecting them to the corresponding circuit substrates, the display component of the present disclosure can achieve a flexible and customizable design of the arrangement of the LED chips. For example, the plurality of LED chips can be arranged to form different patterns according to design requirements. Moreover, by mounting and fixing the LED chips onto the corresponding circuit substrates, the display component can increase the mounting reliability of the LED chips and avoid risks such as loosening or detachment.

### BRIEF DESCRIPTION OF THE ACCOMPANYING DRAWINGS

To more clearly illustrate the technical solutions in the embodiments of the present disclosure, the accompanying drawings required for use in the embodiments will be briefly introduced below. Apparently, the drawings described below are some embodiments of the present disclosure. For those of ordinary skill in the art, other drawings may be obtained based on these drawings without creative efforts.
FIG. 1 is a schematic structural view of a display component in accordance with at least one embodiment of the present disclosure.
FIG. 2 is a schematic structural view of a light emitting unit of the display component shown in FIG. 1.
FIG. 3 is a schematic view showing relevant dimensions of a second encapsulant shown in FIG. 2.
FIG. 4 is a cross-sectional structural view of a display component in accordance with at least one embodiment of the present disclosure.
FIG. 5 is an exploded structural view of the display component shown in FIG. 4.
FIG. 6 is a schematic assembled structural view of a lamp cover shown in FIG. 5.
FIG. 7 illustrates a flowchart of a method of manufacturing a display component in accordance with at least one embodiment of the present disclosure.
FIG. 8 is a schematic view of a corresponding layer structure formed in step S100 shown in FIG. 7.
FIG. 9 is a schematic view of a corresponding layer structure formed in step S200 shown in FIG. 7.
FIG. 10 is a schematic view of a corresponding layer structure formed in step S300 shown in FIG. 7.
FIG. 11 is a schematic view of a corresponding layer structure formed in step S400 shown in FIG. 7.
FIG. 12 illustrates a flowchart of sub-steps of step S300 in the method of manufacturing the display component shown in FIG. 7.
FIG. 13 is a schematic structural view of an electronic device disclosed in accordance with at least one embodiment of the present disclosure.
FIG. 14 is a schematic structural view of the electronic device shown in FIG. 13 from another perspective.
FIG. 15 is a schematic layer structural view of a rear cover assembly of an electronic device in accordance with at least one embodiment of the present disclosure.

### DESCRIPTION OF REFERENCE SIGNS

1-electronic device; 10-display component; 11-light emitting unit; 111-circuit substrate; 112-LED chip; 114-encapsulant; 1111-mounting surface; 1112-connection surface; 13-circuit board; 1141-first encapsulant; 1142-second encapsulant; 14-lamp cover; 15-adhesive layer; 17-decorative sheet; 18-pressure-sensitive button; 100-encapsulant layer; 20-main display module; 30-drive control unit; 40-camera module; 50-housing; 51-middle frame; 60-rear cover assembly; 61-rear cover; 611-first surface; 612-second surface; 63-first film layer; 64-second film layer; 65-color-adjusting anti-shatter layer; 66-electrochromic layer; 67-anti-glare layer; 68-anti-fingerprint layer; S100 to S400-steps of the method of manufacturing the display component; S310 to S330-sub-steps of step S300.

### DETAILED DESCRIPTION OF ILLUSTRATED EMBODIMENTS

To facilitate understanding of the present disclosure, the present disclosure will be described more fully below with reference to the relevant accompanying drawings. Preferred embodiments of the present disclosure are shown in the drawings. However, the present disclosure may be embodied in many different forms and is not limited to the embodiments described herein. On the contrary, these embodiments are provided so that the disclosure of the present disclosure will be more thorough and comprehensive.

The following description of the various embodiments refers to the accompanying drawings to illustrate specific embodiments in which the present disclosure may be practiced. The reference numerals assigned to components herein, such as "first", "second", etc., are merely used to distinguish the objects being described and do not have any sequential or technical meaning. Directional terms used in the present disclosure, such as "upper", "lower", "front", "rear", "left", "right", "inner", "outer", "side", etc., are merely directions with reference to the accompanying drawings. Therefore, the directional terms are used to better and more clearly describe and understand the present disclosure, rather than indicating or implying that the devices or elements referred to must have a particular orientation, or be constructed and operated in a particular orientation, and thus should not be construed as limiting the present disclosure.

In the description of the present disclosure, it should be noted that, unless otherwise expressly specified and limited, the terms "mounted", "connected", and "coupled" should be interpreted in a broad sense. For example, the connection may be a fixed connection, a detachable connection, or an integral connection; it may be a mechanical connection; it may be a direct connection or an indirect connection via an intermediate medium; it may be internal communication between two elements. For those of ordinary skill in the art, the specific meanings of the above terms in the present disclosure may be understood according to the specific circumstances. It should be noted that the terms "first", "second", etc. in the specification, claims, and drawings of the present disclosure are used to distinguish different objects, rather than to describe a particular order. Furthermore, the terms "comprising", "may comprise", "including", or "may include" as used in the present disclosure indicate the presence of the corresponding functions, operations, elements, etc., disclosed herein and do not limit the presence of one or more additional functions, operations, elements, etc. In addition, the terms "comprising" or "including" indicate the presence of the corresponding features, numbers, steps, operations, elements, components, or combinations thereof disclosed in the specification, and do not preclude the presence or addition of one or more other features, numbers, steps, operations, elements, components, or combinations thereof, and are intended to cover non-exclusive inclusion. In the exemplary embodiments of the present disclosure, "the orthographic projection of B falls within the range of the orthographic projection of A" or "the orthographic projection of A includes the orthographic projection of B" means that the boundary of the orthographic projection of B falls within the boundary range of the orthographic projection of A, or the boundary of the orthographic projection of A overlaps with the boundary of the orthographic projection of B.

Unless otherwise defined, all technical and scientific terms used herein have the same meaning as commonly understood by one of ordinary skill in the art to which the present disclosure belongs. The terminology used in the specification of the present disclosure herein is for the purpose of describing particular embodiments only and is not intended to limit the present disclosure.

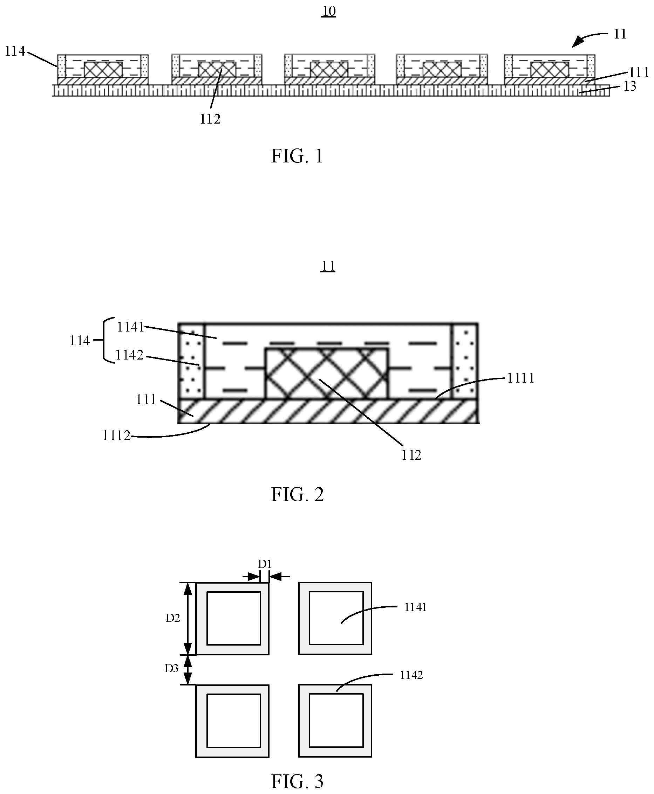

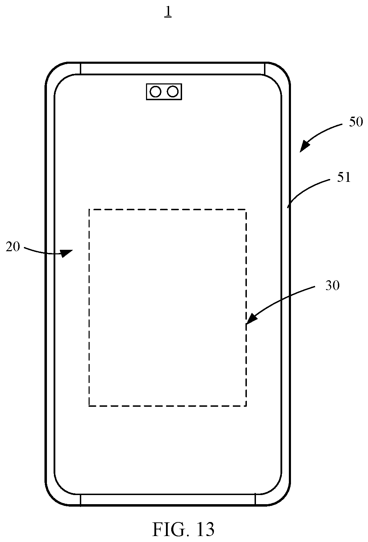

Please refer to FIGS. 1 and 2. FIG. 1 is a schematic structural view of a display component in accordance with at least one embodiment of the present disclosure. FIG. 2 is a schematic structural view of a light emitting unit of the display component shown in FIG. 1. As shown in FIGS. 1 and 2, the display component 10 provided in the at least one embodiment of the present disclosure is applied to an electronic device 1 (as shown in FIG. 13). The electronic device 1 may include, but is not limited to, mobile terminal devices such as smartphones, tablet computers, palmtop computers, handheld game consoles, and personal digital assistants (PDAs).

For ease of description, the specific structures of the electronic device 1 and the display component 10 provided in the present disclosure are further described below using a smartphone as an example.

In at least one embodiment of the present disclosure, the display component 10 includes a plurality of light emitting units 11. Each of the plurality of light emitting units 11 includes a circuit substrate 111, an LED chip 112, and an encapsulant 114. The circuit substrate 111 includes a mounting surface 1111 and a connection surface 1112 opposite to each other. The LED chip 112 is disposed on the mounting surface 1111 and is electrically connected to the circuit substrate 111. The encapsulant 114 is disposed on the mounting surface 1111, is disposed around the LED chip 112, and covers the LED chip 112, thereby encapsulating the LED chip 112 on the circuit substrate 111.

In at least one exemplary embodiment, the LED chip 112 may be a light emitting diode (LED), an organic light-emitting diode (OLED), an active-matrix organic light-emitting diode (AMOLED), a flexible light-emitting diode (FLED), or a quantum dot light-emitting diode (QLED), etc., which is not specifically limited in the present disclosure.

In at least one embodiment of the present disclosure, the display component 10 may further include a circuit board 13. The circuit substrates 111 of a plurality of light emitting units 11 are disposed on the circuit board 13 and electrically connected to the circuit board 13. One or more LED chips 112 are disposed on each of the circuit substrates 111. A gap is defined between each two adjacent ones of the circuit substrates 111. The plurality of light emitting units 11 are arranged in a matrix on the circuit board 13 to form the display component 10.

The plurality of circuit substrates 111 may be separate individual blocks. The separate blocks of the plurality of circuit substrates 111 can be freely arranged on the circuit board 13 as needed. The connection surface 1112 of each circuit substrate 111 is connected to the circuit board 13, such that each circuit substrate 111 is electrically connected to the circuit board 13. It will be appreciated that when the separate blocks of the plurality of circuit substrates 111 are individually arranged, a gap is provided between each two adjacent circuit substrates 111, thereby maintaining insulation between the respective light emitting units 11. Moreover, because the separate blocks of the plurality of circuit substrates 111 are individually arranged, the gaps between the circuit substrates 111 can be reduced or compressed as needed, thereby increasing the arrangement density of the LED chips 112 on the circuit board 13 of the display component 10, and thus increasing the display brightness of the display component 10. Further, a glue such as a waterproof adhesive or an insulating adhesive may be filled in the gaps to improve the overall bonding strength of the display component 10, so that the LED chips 112 are firmly fixed and are not prone to loosening or detachment, and also to improve the insulation between the light emitting units 11 or the waterproof performance of the entire display component 10.

It will be appreciated that in at least one exemplary embodiment, the plurality of circuit substrates 111 may be connected to each other to form a plate-like structure. The plate-like structure is integrally disposed on the circuit board 13 and electrically connected to the circuit board 13. In this case, an insulating partition wall is provided between each adjacent pair of the light emitting units 11, so as to achieve electrical insulation between the light emitting units 11 by means of the insulating partition walls.

In at least one embodiment of the present disclosure, the plurality of light emitting units 11 may be regularly or irregularly arranged on the circuit board 13 according to actual needs and design requirements. It will be appreciated that the arrangement may be an irregular polygonal arrangement, a rectangular arrangement, a rhombus arrangement, a triangular arrangement, a star-shaped arrangement, etc., which is not specifically limited in the present disclosure. For example, three adjacent light emitting units 11 arranged on the circuit board 13 may form a light emitting unit group. The three LED chips 112 in the light emitting unit group are respectively configured to output light of different colors (e.g., the three primary colors: red, green, and blue), and by adjusting the light output ratios of the three LED chips 112 in the light emitting unit group, light mixing or dimming can be achieved.

In at least one embodiment of the present disclosure, the circuit board 13 may integrate electronic components such as a processor, a storage unit, a baseband chip, and a power management unit of the electronic device 1. The circuit board 13 may be a printed circuit board (PCB), which includes an insulating base plate, connecting wires, and pads for assembling and soldering electronic components, and has the dual functions of providing conductive traces and an insulating base plate. The circuit board may be a single-sided board, a double-sided board, or a multi-layer board, and can replace complex wiring, enabling routing and electrical connection or insulation between various electronic components, thereby providing the required electrical characteristics.

In at least one embodiment of the present disclosure, the encapsulant 114 of each light emitting unit 11 includes a first encapsulant 1141 and a second encapsulant 1142. The first encapsulant 1141 is disposed on the circuit substrate 111 and encapsulates the LED chip 112. The second encapsulant 1142 is disposed around the first encapsulant 1141, and the second encapsulant 1142 and the circuit substrate 111 cooperatively define a cavity. The LED chip 112 is disposed within the cavity, thereby encapsulating the LED chip 112 on the circuit substrate 111.

In at least one embodiment of the present disclosure, the first encapsulant 1141 may be made of a silicone elastic material. For example, the first encapsulant 1141 may be made of a fluorescent glue, which has the advantages of high light transmittance, high refractive index, good thermal stability, low hygroscopicity, and the like. Moreover, the first encapsulant 1141 is also used to conduct and dissipate heat generated by the LED chip 112 surrounded by the first encapsulant 1141 after light emission.

In this exemplary embodiment, a light-reflecting material (e.g., aluminum oxide, titanium dioxide) may be added to the first encapsulant 1141 to enhance the light-emitting efficiency of the LED chip 112 or to improve the light mixing effect.

In at least one embodiment of the present disclosure, the second encapsulant 1142 is disposed on the mounting surface 1111 of the circuit substrate 111. A top surface of the second encapsulant 1142 is flush with a top surface of the first encapsulant 1141, and the second encapsulant 1142 surrounds an outer side of the first encapsulant 1141. The second encapsulant 1142 may be made of a dam glue, which can prevent optical crosstalk between the light emitting units 11 and thus avoid light interference.

Please refer to FIG. 3, FIG. 3 is a schematic view showing relevant dimensions of a second encapsulant shown in FIG. 2. As shown in FIG. 3, the second encapsulant 1142 as a whole may be a closed frame formed by a dam wall. A wall thickness D1 of the dam wall of the second encapsulant 1142 is greater than or equal to 0.035 mm and less than or equal to 0.15 mm. For example, 0.035 mm, 0.04 mm, 0.05 mm, 0.07 mm, 0.08 mm, 0.085 mm, 0.1 mm, 0.11 mm, 0.115 mm, 0.12 mm, 0.14 mm, 0.15 mm, or other values, which is not specifically limited in the present disclosure.

In at least one embodiment of the present disclosure, when a shape of an orthographic projection of the second encapsulant 1142 onto the circuit substrate 111 is a rectangular frame, a side length D2 of the rectangle is greater than or equal to 0.55 mm, and a minimum distance D3 between any two adjacent ones of the second encapsulants 1142 is greater than or equal to 0.2 mm. Alternatively, when the shape of the orthographic projection of the second encapsulant 1142 onto the circuit substrate 111 is an annular frame, an outer diameter D2 of the annulus is greater than or equal to 0.55 mm, and a minimum distance D3 between any two adjacent ones of the second encapsulants 1142 is greater than or equal to 0.2 mm.

It will be appreciated that by setting the minimum distance between any two adjacent ones of the second encapsulants 1142, interference during assembly can be avoided, and short circuits between adjacent circuit substrates 111 can also be prevented. If the distance between two adjacent second encapsulants 1142 is too small, for example, if the minimum distance between any two adjacent ones of the second encapsulants 1142 is less than 0.2 mm, tolerances during assembly cannot be ensured, causing interference at the assembly positions. Moreover, when the circuit substrates 111 are mounted on the circuit board 13 by soldering, solder paste may easily bridge two adjacent circuit substrates 111, causing a short circuit. In addition, setting the minimum distance between two adjacent second encapsulants 1142 also facilitates heat dissipation of the light emitting units 11 and the display component 10.

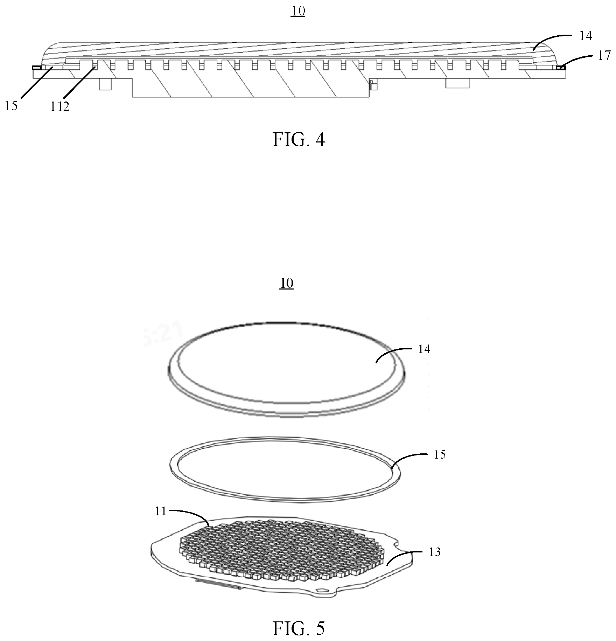

Please refer to FIGS. 4 and 5 together. FIG. 4 is a cross-sectional structural view of a display component in accordance with at least one embodiment of the present disclosure, and FIG. 5 is an exploded structural view of the display component shown in FIG. 4. As shown in FIGS. 4 and 5, the display component 10 of the present disclosure may further include a lamp cover 14 covering all of the light emitting units 11. Specifically, the display component 10 includes one lamp cover 14. The one lamp cover 14 is disposed on the mounting surface 1111 of the circuit substrate 111 and covers all of the light emitting units 11 on the mounting surface 1111 of the circuit substrate 111.

In at least one embodiment of the present disclosure, the display component 10 may further include a plurality of lamp covers 14, each lamp cover 14 covering one or more of the light emitting units 11. Specifically, the plurality of lamp covers 14 are all disposed on the mounting surface 1111 of the circuit substrate 111, and each lamp cover 14 covers one or more light emitting units 11 on the mounting surface 1111 of the circuit substrate 111.

In at least one embodiment of the present disclosure, each lamp cover 14 includes an effect layer located in a light emission direction of the one or more of the light emitting units 11 covered by the lamp cover 14. For example, the effect layer is disposed on an inner top surface or an outer top surface of the lamp cover 14, allowing light from the one or more of the light emitting units 11 covered by the lamp cover 14 to pass through. The effect layer is configured to transmit light emitted by the LED chips 112 of the one or more of the light emitting units 11 which are covered by the lamp cover 14 and produce a predetermined display effect, such as a predetermined color, a predetermined brightness, a predetermined texture, a frosted display, or the like.

In at least one exemplary embodiment, the effect layer of each of the lamp covers 14 may include one or more of a color filter film, a light-transmitting film having a predetermined transmittance, a textured film, a light-diffusing film, and a brightness enhancement film.

In at least one embodiment of the present disclosure, an inner surface of each lamp cover 14 has a plurality of light-transmitting regions, and each of the plurality of light-transmitting regions corresponds to at least one of the LED chips 112. Light emitted by each of the LED chips 112 transmits through a corresponding light-transmitting region of the lamp cover 14 to produce different light output effects, such as different colors, different brightness levels, different textures, and the like.

In at least one embodiment of the present disclosure, the lamp cover 14 includes a plurality of light-shielding portions in a direction parallel to the light emission direction of the light emitting units 11, and each of the light-shielding portions corresponds to one of the second encapsulants 1142, and the light-shielding portion abuts against the corresponding second encapsulant 1142 of the light emitting unit 11. For example, the lamp cover 14 includes a plurality of light-shielding portions protruding toward the light emitting units 11. The light-shielding portions are located in a light emission path of the light emitting units 11, and an end of each light-shielding portion abuts against a side of the second encapsulant 1142 of the light emitting unit 11 facing away from the circuit substrate 111, such that the light-shielding portion covers the light emitting unit 11. The light-shielding portions are configured to prevent optical crosstalk between the LED chips 112 of the light emitting units 11, thereby preventing light interference between different light emitting units 11.

In at least one embodiment of the present disclosure, the lamp cover 14 may be a glass cover, a sapphire cover, or a plastic cover. The lamp cover 14 has a relatively high light transmittance to facilitate the emission of light from the light emitting units 11. The outer shape of the lamp cover 14 may be circular, rounded rectangular, race-track shaped, pentagonal, hexagonal, or other shapes. The lamp cover 14 may have relatively high scratch resistance to prevent the lamp cover 14 from being easily scratched. It will be appreciated that a surface of the lamp cover 14 may be coated with an optical film layer or other film layers for enhancing performance. The optical film layer may include one or more of an infrared filtering layer, an ultraviolet filtering layer, an anti-reflection film, and a strengthening layer.

In at least one embodiment of the present disclosure, the transmittance of the lamp cover 14 may be 5% to 20%, for example, 6%, 6.5%, 7%, 7.2%, 8%, 8.5%, 9%, 10%, 10.4%, 11%, 12%, 12.5%, 12.8%, 13%, 13.5%, 14%, or other values, which is not specifically limited in the present disclosure. Therefore, the transmittance design of the lamp cover 14 can ensure that when the LED chips 112 are in a non-operating state, the LED chips 112 are not too conspicuous from the outside, providing a good visual effect. The color temperature of the LED chips 112 may be 5000K to 9000K, for example, 5000K, 5500K, 5580K, 5800K, 6000K, 6500K, 7000K, 7050K, 7250K, 7500K, 7600K, 7900K, 8000K, 8300K, 8500K, 8600K, 8800K, 8900K, 8950K, 9000K, or other values, which is not specifically limited in the present disclosure. Therefore, the color temperature of the LED chips 112 can ensure that, after passing through the lamp cover 14 having the above transmittance, the light emitted by the LED chips 112 is not too dazzling, and in terms of visual effect, it is not easy for a user to see individual LED chips, thereby ensuring an aesthetically pleasing appearance. Thus, the display component 10 can ensure controllable display brightness and good visual effect without causing glare.

As shown in FIGS. 4 and 5, in at least one embodiment of the present disclosure, the display component 10 may further include an adhesive layer 15 disposed between the lamp cover 14 and the mounting surface 1111 of the circuit substrate 111. The lamp cover 14 is bonded and fixed to the circuit substrate 111 via the adhesive layer 15. The adhesive layer 15 may be an optically clear adhesive layer, a glue layer, or a double-sided adhesive tape layer. The adhesive layer 15 can reliably fix the lamp cover 14 to the mounting surface 1111 of the circuit substrate 111, and can also provide cushioning and shock-absorbing effects when the electronic device 1 is accidentally dropped. Moreover, a circumferential portion of the lamp cover 14 is bonded and fixed to the adhesive layer 15, thereby improving the sealing performance between the lamp cover 14 and the circuit substrate 111, and thus improving the waterproof and dustproof performance of the electronic device 1.

In at least one embodiment of the present disclosure, the display component 10 may further include a plurality of driving circuits. The same driving circuit is electrically connected to one or more of the LED chips 112 for controlling the one or more LED chips 112. When one driving circuit is electrically connected to one LED chip 112, the driving circuit independently controls parameters such as lighting, brightness, and color of the one LED chip 112. Therefore, by independently controlling each LED chip 112, finer brightness control and adjustment can be achieved, the illumination intensity can be adjusted as needed, energy can be saved, and overload or overheating of certain LED chips can be avoided, thereby extending the service life of the entire display component 10. In addition, by independently controlling each LED chip 112, local dimming can be achieved, only lighting the required LED chips, reducing unnecessary energy consumption, and adapting to different lighting requirements and environmental changes. Furthermore, by independently controlling each LED chip 112, fault diagnosis and maintenance can be facilitated. If a particular LED chip 112 fails, it can be replaced individually without affecting the normal operation of other LED chips.

In an embodiment of the present disclosure, the driving circuit may be a driver integrated circuit (Driver IC), which may be electrically connected to a microcontroller unit (MCU) of the display component 10 via a flexible printed circuit (FPC). It will be appreciated that the display component 10 may further include various connectors for achieving electrical connections between different electronic components, between electronic components and circuit boards, between different circuit boards, and the like. For example, the display component 10 includes a BTB connector for connecting different electronic boards or circuit boards to achieve transmission of electricity, signals, and data. The display component 10 may further include a ZIF connector, which is used for connecting cables to circuit boards, particularly suitable for scenarios requiring frequent mating and unmating. When connecting, no mechanical force is required, and a smooth connection can be achieved by releasing a latching mechanism.

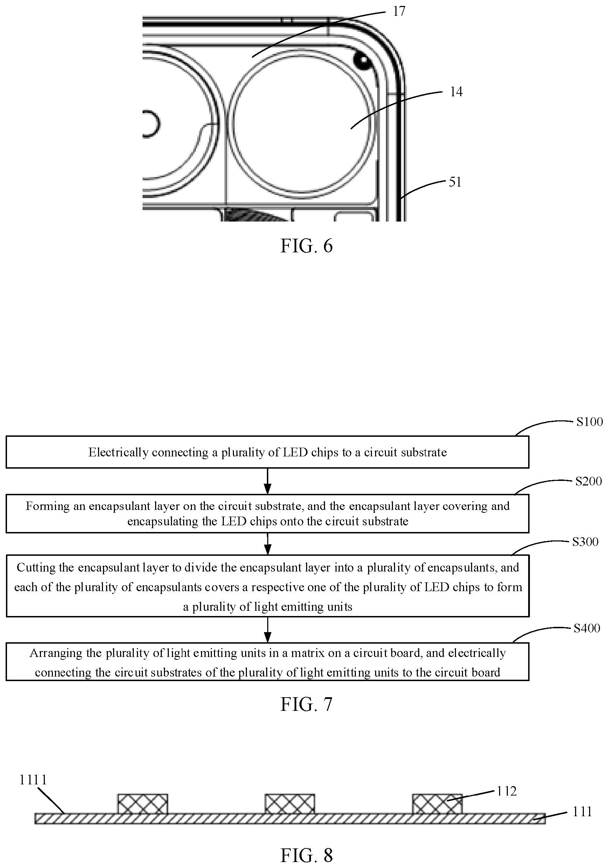

Please refer to FIG. 6, FIG. 6 is a schematic assembled structural view of a lamp cover shown in FIG. 5. In at least one embodiment of the present disclosure, the display component 10 may further include at least one decorative sheet 17 each surrounding an outer edge of the at least one lamp cover 14. For example, the decorative sheet 17 may be an annular sheet body attached to the mounting surface 1111 of the circuit substrate 111 and disposed around the outer edge of the lamp cover 14. That is, the decorative sheet 17 takes the lamp cover 14 as a boundary, so that the appearance surface is not affected by the shapes of other electronic components (e.g., the circuit board). It will be appreciated that the decorative sheet 17 can shield other electronic components on the circuit substrate 111 and be visible through a transparent rear cover, which is beneficial to improving the appearance performance and overall aesthetics of the electronic device 1. Moreover, the decorative sheet 17 can also be used to provide label information of the electronic components to the user. Through the decorative sheet 17, the user can learn the distribution of relevant electronic components inside the electronic device 1, so that the user can know, through the decorative sheet 17, the installation positions of some electronic components, the names corresponding to the electronic components, the functions of the electronic components, and other characteristic information, thereby enhancing the information communication of the electronic device 1.

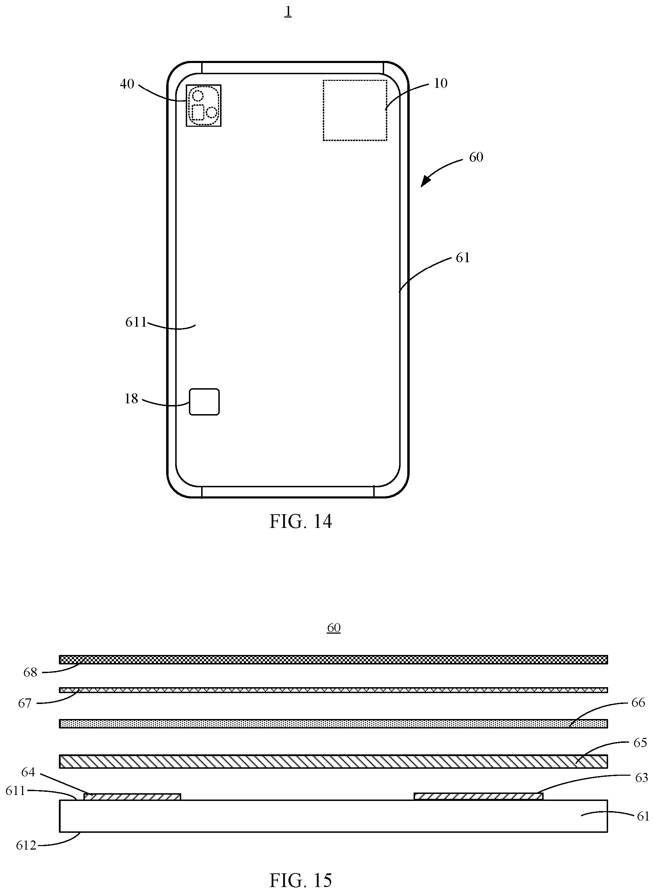

In at least one embodiment of the present disclosure, the display component 10 may further include at least one pressure-sensitive button 18 (as shown in FIG. 14). The pressure-sensitive button 18 is disposed on a rear cover or a frame of the electronic device 1, and is electrically connected to the LED chips 112 for controlling the display component 10 to be turned on or off. For example, the pressure-sensitive button 18 is electrically connected to the circuit board and the display component 10, and can control the display component 10 to display corresponding image information, such as controlling the display component 10 to light up the screen. For another example, long pressing the pressure-sensitive button 18 can turn off the screen of the display component 10, and double-clicking the pressure-sensitive button 18 can adjust the display brightness of the display component 10 or change the display pattern. It will be appreciated that the manner in which the pressure-sensitive button 18 controls the display component 10 can be adjusted and preset according to specific needs, which is not specifically limited in the present disclosure.

In at least one embodiment of the present disclosure, the display component 10 may be a dot matrix screen for displaying functional image information to the user. The functional image information includes, but is not limited to, image information such as time, date, preset patterns, logos, etc., to increase the functional diversity, aesthetics, and personalized design of the electronic device 1.

In summary, the display component 10 disclosed in the embodiments of the present disclosure is applied to an electronic device 1. The display component 10 includes a plurality of light emitting units 11. Each light emitting unit 11 includes a circuit substrate 111, an LED chip 112, and an encapsulant 114. The circuit substrate 111 includes a mounting surface 1111. The LED chip 112 is disposed on the mounting surface 1111 and is electrically connected to the circuit substrate 111. The encapsulant 114 is disposed on the mounting surface 1111, is disposed around the LED chip 112, and covers the LED chip 112, thereby encapsulating the LED chip 112 on the circuit substrate 111. Therefore, by respectively disposing the plurality of LED chips 112 on their respective corresponding circuit substrates 111 and electrically connecting them to the corresponding circuit substrates 111, the display component 10 of the present disclosure can achieve a flexible and customizable design of the arrangement of the LED chips 112. For example, the plurality of LED chips 112 can be arranged into different patterns according to design requirements. Furthermore, by mounting and fixing the LED chips 112 onto the corresponding circuit substrates 111, the display component 10 can increase the mounting reliability of the LED chips 112 and avoid risks such as loosening or detachment.

Furthermore, by disposing the first encapsulant 1141 to encapsulate the LED chip 112 on the circuit substrate 111, and by disposing the second encapsulant 1142 around the first encapsulant 1141, not only can the effective light-emitting area of the LED chip 112 be increased, but also optical crosstalk between adjacent LED chips 112, which may cause light interference between adjacent optical paths, can be prevented, thereby improving the appearance refinement and light effect of the display component 10.

Based on the same technical concept, embodiments of the present disclosure further provide a method of manufacturing a display component. Please refer to FIG. 7, FIG. 7 illustrates a flowchart of a method of manufacturing a display component in accordance with at least one embodiment of the present disclosure. The method of manufacturing the display component is used to form the above-described display component 10. For descriptions of the structures involved in the method of manufacturing the display component that are the same as those of the display component 10, please refer to the relevant descriptions of the display component 10 in the above embodiments, which will not be repeated here. As shown in FIG. 7, the method of manufacturing the display component specifically includes the following steps.

S100: a plurality of LED chips 112 are electrically connected to a circuit substrate 111.

Specifically, please refer to FIG. 8, FIG. 8 is a schematic view of a corresponding layer structure formed in step S100 shown in FIG. 7. A circuit substrate 111 is provided, the circuit substrate including a mounting surface 1111. A plurality of LED chips 112 are disposed on the mounting surface 1111 and electrically connected to the circuit substrate 111.

S200: an encapsulant layer 100 is formed on the circuit substrate 111, the encapsulant layer 100 covers and encapsulates the LED chips 112 onto the circuit substrate 111.

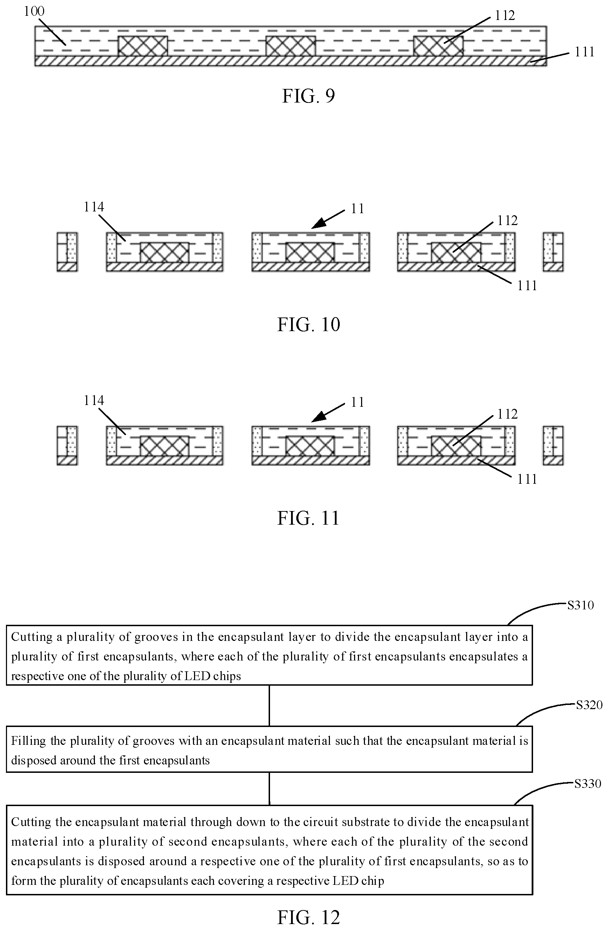

Specifically, please refer to FIG. 9, FIG. 9 is a schematic view of a corresponding layer structure formed in step S200 shown in FIG. 7. After electrically connecting the plurality of LED chips 112 to the circuit substrate 111, an encapsulant layer 100 is formed on the circuit substrate 111. The encapsulant layer 100 encapsulates the LED chips 112 and covers the plurality of LED chips 112 onto the circuit substrate 111.

S300: the encapsulant layer 100 is cut to divide the encapsulant layer 100 into a plurality of encapsulants 114, and each of the plurality of encapsulants 114 covers a respective one of the plurality of LED chips 112 to form a plurality of light emitting units 11.

Specifically, please refer to FIG. 10, FIG. 10 is a schematic view of a corresponding layer structure formed in step S300 shown in FIG. 7. After forming the encapsulant layer 100 on the circuit substrate 111 to encapsulate and cover the plurality of LED chips 112 onto the circuit substrate 111, the encapsulant layer 100 is cut to divide the encapsulant layer 100 into a plurality of encapsulants 114, each encapsulant 114 covering one of the LED chips 112 to form a plurality of light emitting units 11.

S400: the plurality of light emitting units 11 are arranged in a matrix on a circuit board 13, and electrically connect the circuit substrates 111 of the plurality of light emitting units 11 to the circuit board 13.

Specifically, please refer to FIG. 11, FIG. 11 is a schematic view of a corresponding layer structure formed in step S400 shown in FIG. 7. After cutting the encapsulant layer 100 to divide the encapsulant layer 100 into a plurality of encapsulants 114, each encapsulant 114 covers one of the LED chips 112, so as to form a plurality of light emitting units 11, the plurality of light emitting units 11 are arranged in a matrix on a circuit board 13, and the circuit substrates 111 of the plurality of light emitting units 11 are electrically connected to the circuit board 13. Each circuit substrate 111 corresponds to one or more LED chips 112. A gap is defined between each two adjacent ones of the circuit substrates 111. The plurality of light emitting units 11 are arranged in a matrix on the circuit board 13 to form the display component 10.

Please refer to FIG. 12, FIG. 12 illustrates a flowchart of sub-steps of step S300 in the method of manufacturing the display component shown in FIG. 7. Step S300 includes the following sub-steps.

S310: A plurality of grooves are cut in the encapsulant layer 100 to divide the encapsulant layer 100 into a plurality of first encapsulants 1141, where each of the plurality of first encapsulants 1141 encapsulates a respective one of the plurality of LED chips 112.

S320: The plurality of grooves are filled with an encapsulant material such that the encapsulant material is disposed around the first encapsulants 1141.

S330: The encapsulant material is cut through down to the circuit substrate 111 to divide the encapsulant material into a plurality of second encapsulants 1142, where each of the plurality of the second encapsulants 1142 is disposed around a respective one of the plurality of first encapsulants 1141, so as to form the plurality of encapsulants 114 each covering a respective LED chip 112.

In at least one embodiment of the present disclosure, the first encapsulant 1141 may be made of a silicone elastic material. For example, the first encapsulant 1141 may be made of a fluorescent glue, which has the advantages of high light transmittance, high refractive index, good thermal stability, low hygroscopicity, and the like. Moreover, the first encapsulant 1141 is also used to conduct and dissipate heat generated by the LED chip 112 after light emission.

In at least one embodiment of the present disclosure, the second encapsulant 1142 is disposed on the mounting surface 1111 of the circuit substrate 111. A top surface of the second encapsulant 1142 is flush with a top surface of the first encapsulant 1141, and the second encapsulant 1142 surrounds an outer side of the first encapsulant 1141. The second encapsulant 1142 may be made of a dam glue, which can prevent optical crosstalk between the light emitting units 11 and thus avoid light interference.

Based on the same technical concept, embodiments of the present disclosure further provide an electronic device. The electronic device includes a middle frame, a rear cover, and the above-described display component 10, where the display component 10 is disposed between the middle frame and the rear cover. Since the display component 10 has been described in detail in the above embodiments, details thereof will not be repeated here. Therefore, the electronic device provided in the embodiments of the present disclosure achieves the technical effects of the technical solutions in any of the above embodiments. Descriptions of structures or terms that are the same as or corresponding to those in the above embodiments will not be repeated here.

Please refer to FIGS. 13 and 14. FIG. 13 is a schematic structural view of an electronic device disclosed in accordance with at least one embodiment of the present disclosure, and FIG. 14 is a schematic structural view of the electronic device shown in FIG. 13 from another perspective. As shown in FIGS. 13 and 14, the electronic device 1 provided in the embodiments of the present disclosure further includes a main display module 20. The main display module 20 has display functions and touch control functions, meaning that the electronic device 1 can be operated by touching the main display module 20. The main display module 20 may include structural layers such as a touch screen, a light-emitting layer, a backplane layer, and a substrate layer, the specific structure of which may be selected according to different products. In at least one embodiment of the present disclosure, the main display module 20 may be a liquid crystal display (LCD), an organic light-emitting diode (OLED) display, an active-matrix organic light-emitting diode (AMOLED) display, a flexible light-emitting diode (FLED) display, or a quantum dot light-emitting diode (QLED) display. The main display module 20 is configured to display image information and provide a user interface.

In at least one embodiment of the present disclosure, the electronic device 1 further includes a drive control unit 30. The drive control unit 30 is electrically connected to the LED chips 112 of the display component 10, and is configured to control the display component 10 to light up or present different display patterns according to a preset manner.

In at least one embodiment of the present disclosure, the electronic device 1 may further include a camera module 40. The camera module 40 may include a plurality of cameras for taking photos and recording videos. The plurality of cameras may be any different cameras selected from a periscope camera, a conventional camera, a wide-angle camera, an ultra-wide-angle camera, a telephoto camera, a monochrome camera, and a depth camera.

It will be appreciated that the camera module 40 may further include an image sensor, an optical filter, an image signal processor, a flash, focusing and optical image stabilization components, and other auxiliary components to improve the imaging quality of the camera module 40.

As shown in FIGS. 13 and 14, the electronic device 1 further includes a housing 50 and a rear cover assembly 60. The housing 50 is configured to position, support, and protect the display component 10, the main display module 20, the drive control unit 30, a battery module, the camera module 40, and the rear cover assembly 60. The circuit board 13 is mounted and fixed within the housing 50. The circuit board 13 is electrically connected to the battery module and the drive control unit 30, respectively. The circuit board 13 may also integrate electronic components such as a processor, a storage unit, a baseband chip, and a power management unit of the electronic device 1.

The housing 50 includes a middle frame 51. The main display module 20 and the rear cover assembly 60 are respectively located on opposite sides of the middle frame 51 and are respectively fixedly connected to the middle frame 51. Specifically, the main display module 20 and the rear cover assembly 60 may be respectively fixedly connected to the middle frame 51 by a dispensing process to improve the reliability and stability of the connection. In at least one embodiment of the present disclosure, the main display module 20 and the rear cover assembly 60 are respectively fixedly connected to opposite sides of the housing 50. The main display module 20, the rear cover assembly 60, and the housing 50 together define an accommodation space for accommodating and installing electronic components of the electronic device 1, such as the battery module, the camera module 40, the display component 10, and the circuit board. Specifically, a first accommodation space may be formed between the middle frame 51 and the rear cover assembly 60, and at least a portion of the above electronic components may be disposed within the first accommodation space. A second accommodation space may be formed between the middle frame 51 and the main display module 20, and a portion of the above electronic components may be disposed within the second accommodation space. It will be appreciated that the battery module can provide electrical power to the main display module 20, the drive control unit 30, the camera module 40, and the display component 10.

The middle frame 51 includes a frame. The frame may be made of a metal material such as aluminum alloy, magnesium alloy, or stainless steel, or a ceramic material, a glass material, a plastic material, etc., but is not limited thereto. The frame may be provided with function keys such as a volume key and a screen-off key cutting therethrough, and the function keys are electrically connected to the processor of the electronic device 1. In at least one exemplary embodiment, the frame may be manufactured by at least one of injection molding, compression molding, extrusion molding, forging, die casting, and computer numerical control (CNC) machining.

In at least one embodiment of the present disclosure, the frame may be made entirely or partially of a transparent material (including but not limited to glass, transparent plastic, etc.). By forming the frame from a transparent material, not only is manufacturing and processing facilitated, but electronic components inside the electronic device 1 can also be visualized.

In at least one embodiment of the present disclosure, the rear cover assembly 60 includes a rear cover 61 of a transparent design. The rear cover 61 is disposed opposite to the main display module 20 and is detachably mounted to the housing 50. The display component 10 is disposed between the middle frame 51 and the rear cover 61. The rear cover 61 includes a first surface 611 and a second surface 612 opposite to each other (as shown in FIG. 15). The first surface 611 is an outer surface of the rear cover 61 and is visible to a user. The second surface 612 is an inner surface of the rear cover 61 and faces the interior of the electronic device 1.

In at least one embodiment of the present disclosure, the pressure-sensitive button 18 is disposed on the first surface 611 of the rear cover 61 and forms an opaque adhesive patch region on the first surface 611. A user can perform input operations of the pressure-sensitive button 18 by pressing the opaque adhesive patch region.

It will be appreciated that, to prevent accidental operations when gripping the electronic device 1, the pressure-sensitive button 18 is disposed at a position on the first surface 611 of the rear cover 61 close to an edge.

In at least one embodiment of the present disclosure, the display component 10 further includes at least one lamp cover 14. Each of the at least one lamp cover 14 covers one or more of the light emitting units 11. A surface of each of the at least one lamp cover 14 facing away from the one or more of the light emitting units 11 covered thereby abuts against the rear cover 61 of the electronic device 1. Alternatively, a side of the lamp cover 14 facing away from the one or more of the light emitting units 11 forms part of the rear cover 61 of the electronic device 1. It will be appreciated that, since the lamp cover 14 forms the outermost surface of the electronic device 1, the thickness of the rear cover 61 at that position can be reduced, thereby reducing the overall thickness of the rear cover assembly 60. At the same time, because the lamp cover 14 forms the outermost surface of the electronic device 1, light does not need to pass through relevant portions of the rear cover 61 after exiting the lamp cover 14, thereby avoiding the influence of surface designs of the rear cover 61 (such as surface texture, color, etc.) on the light effect of the lamp array.

In at least one embodiment of the present disclosure, the rear cover 61 may be a battery cover of the electronic device 1 made of a transparent material (e.g., glass, transparent plastic, etc.).

In at least one embodiment of the present disclosure, the rear cover 61 and the frame may be made entirely or partially of a transparent material (e.g., glass, transparent plastic, etc.). This not only facilitates manufacturing and processing, but also allows at least some electronic components of the electronic device 1, such as the camera module 40 and the display component 10, to be visible through the transparent rear cover 61. A user can see at least some of the electronic components and their arrangement on the back side of the electronic device 1, which is beneficial for enhancing the technological feel, personalization, and overall aesthetics of the electronic device 1.

In at least one embodiment of the present disclosure, after the rear cover 61 is fixedly connected to the middle frame 51, the first surface 611 of the rear cover 61 is exposed so that a user can directly view the appearance of the rear cover 61, allowing the first surface 611 of the rear cover 61 to present an aesthetic effect, thereby improving the appearance characteristics of the electronic device 1. Moreover, the rear cover 61 is made of a glass material, such as high-alumina-silicate glass, nano-microcrystalline glass, or the like, which has characteristics such as high hardness, wear resistance, and scratch resistance. It will be appreciated that the first surface 611 (i.e., the appearance surface) of the rear cover 61 is a relatively smooth surface, so that the rear cover 61 has good appearance characteristics.

Please refer to FIG. 15, FIG. 15 is a schematic layer structural view of a rear cover assembly of an electronic device in accordance with at least one embodiment of the present disclosure. In at least one embodiment of the present disclosure, the rear cover assembly 60 further includes a first film layer 63 and a second film layer 64. The first film layer 63 is attached to the first surface 611 of the rear cover 61, and a position of the first film layer 63 corresponds to a position of the display component 10. The second film layer 64 is attached to the first surface 611 of the rear cover 61, and a position of the second film layer 64 corresponds to a position of the camera module 40.

In at least one embodiment of the present disclosure, the first film layer 63 may be an anti-reflection (AR) film, which can increase the hardness of a portion of the rear cover 61 corresponding to the display component 10 and prevent the first surface 611 at that portion from being scratched. Therefore, by providing the first film layer 63 on the rear cover 61 at a position corresponding to the display component 10, the hardness of the surface at that position is increased, enhancing scratch resistance and thus improving the display clarity of the display component 10, thereby enhancing the display effect of the display component 10. For example, the hardness of the first surface 611 at the position where the first film layer 63 is attached may be 7H.

In at least one embodiment of the present disclosure, the second film layer 64 may be an anti-reflection film, which can increase the hardness of a portion of the rear cover 61 corresponding to the camera module 40 and prevent the first surface 611 at that portion from being scratched. In addition, by performing anti-reflection treatment on the first surface 611 of the rear cover 61 at the position corresponding to the camera module 40, the light transmittance of the first surface 611 corresponding to the camera module 40 can be improved, and the reflectivity of the glass can be reduced to achieve the purpose of increasing transmittance. Therefore, by providing the second film layer 64 on the rear cover 61 at the position corresponding to the camera module 40, the hardness of the surface corresponding to the camera module 40 is increased, enhancing scratch resistance, thereby improving the light transmittance associated with the camera module 40 and thus enhancing the photographing effect of the camera module 40. For example, the hardness of the first surface 611 at the position where the second film layer 64 is attached may be 7H.

In at least one embodiment of the present disclosure, the first film layer 63 and the second film layer 64 may be formed directly on the first surface 611 of the rear cover 61 by vacuum evaporation coating. Specifically, by performing anti-reflection coating treatment on the first surface 611 of the rear cover 61 at the position corresponding to the display component 10, an anti-reflection film is formed; by performing anti-reflection coating treatment on the first surface 611 of the rear cover 61 at the position corresponding to the camera module 40, an anti-reflection film having a hardness of 7H is formed.

In at least one exemplary embodiment, the thickness of the first film layer 63 and the second film layer 64 may be 650 nm to 750 nm, for example, 650 nm, 670 nm, 680 nm, 700 nm, 710 nm, 730 nm, 740 nm, 750 nm, or other values, which is not specifically limited in the present disclosure.

Therefore, the rear cover 61 adopts an overall transparent design, achieving a hierarchical overall display of the electronic device 1 and solving the problem of lack of overall appearance integrity of rear covers in related art electronic devices. Moreover, by providing the first film layer 63 and the second film layer 64 on the outer surface (i.e., the first surface 611) of the rear cover 61 at positions corresponding to the display component 10 and the camera module 40, respectively, not only is the protection of the display component 10 and the camera module 40 increased, and the integrity and aesthetics of the electronic device 1 improved, but also the rear cover assembly 60 does not require a decorative ring (CAM Deco) design, thereby making the structure of the rear cover 61 simple, the appearance more minimalist, providing high overall appearance integrity, and further improving the overall appearance integrity of the electronic device 1.

In at least one embodiment of the present disclosure, as shown in FIG. 15, the rear cover assembly 60 further includes a color-adjusting anti-shatter layer 65. The color-adjusting anti-shatter layer 65 is attached to the first surface 611 of the rear cover 61 and covers the first film layer 63 and the second film layer 64. The color-adjusting anti-shatter layer 65 is configured to adjust the color and brightness of an image displayed by the display component 10. Therefore, the color-adjusting anti-shatter layer 65 is color-adjustable. By attaching the color-adjusting anti-shatter layer 65 to the first surface 611 of the rear cover 61, the color and brightness of the image displayed by the display component 10 can be adjusted, allowing the display component 10 to display a preset image color and brightness. Moreover, by providing the color-adjusting anti-shatter layer 65 to adjust the screen brightness and color of the display component 10, the display component 10 does not require an additional dot matrix screen cover on the rear cover 61, making the structure of the electronic device 1 simpler and the appearance more minimalist, and further improving the overall appearance integrity, aesthetics, and visual display effect of the electronic device 1.

It will be appreciated that by attaching the color-adjusting anti-shatter layer 65 to a portion of the first surface 611 of the rear cover 61, impact can be effectively buffered, the screen can be prevented from cracking, or the glass rear cover can be prevented from shattering and scattering upon accidental impact of the electronic device 1, thereby reducing hidden damage to the glass rear cover, while also maintaining the unique gloss, texture, and improved surface hardness of the tempered glass rear cover. The color-adjusting anti-shatter layer 65 may sequentially include: a protective film, a hardening layer, a transparent polyester film, an adhesive layer, and a release film.

In at least one embodiment of the present disclosure, the rear cover assembly 60 may further include a bonding layer disposed between the color-adjusting anti-shatter layer 65 and the first surface 611 of the rear cover 61. The color-adjusting anti-shatter layer 65 is bonded and fixed to the rear cover 61 via the bonding layer. The bonding layer may be an optically clear adhesive layer, a glue layer, or a double-sided adhesive tape layer. The bonding layer can reliably fix the color-adjusting anti-shatter layer 65 to the first surface 611 of the rear cover 61, and can also provide a cushioning and shock-absorbing effect when the electronic device 1 is accidentally dropped. Moreover, a circumferential portion of the rear cover 61 is bonded and fixed to the bonding layer, thereby improving the sealing performance between the rear cover 61 and the color-adjusting anti-shatter layer 65, and thus improving the waterproof and dustproof performance of the electronic device 1.

In other embodiments of the present disclosure, the rear cover 61 may further include at least one decorative region disposed on the first surface 611 of the rear cover 61, where the decorative regions are respectively provided with the same or different texture patterns. It will be appreciated that when there are a plurality of decorative regions, the plurality of decorative regions may be disposed adjacent to each other, spaced apart from each other, or spliced together to form different patterns. The plurality of decorative regions may have the same texture pattern or different texture patterns. For example, the plurality of decorative regions may form a texture pattern, or a texture pattern may be formed by glazing or the like, thereby achieving a better aesthetic effect and thus improving the appearance characteristics of the electronic device 1.

In at least one exemplary embodiment, a position of one of the decorative regions may correspond to a position of a coil in the electronic device 1. In order to increase the layering and aesthetics of the electronic device 1, the shape of the decorative region may be configured to match the shape of the coil, and accordingly, the texture pattern and color of the decorative region are also consistent with the winding manner and color of the coil.

In this embodiment, by designing the texture and color of the decorative regions, the transparent rear cover can present various visual effects. A UV texture transfer technology may be used to design the texture of the decorative regions, i.e., a process of replicating fine texture structures using liquid UV glue that cures under ultraviolet light, thereby producing textures such as brushed lines, sunburst lines, sandblasted textures, 3D surfaces, leather textures, iridescent effects, bulging effects, matte surfaces, gloss surfaces, and high-gloss surfaces. The color may be a single color or a gradient color, which is not specifically limited in the present disclosure.

In at least one embodiment of the present disclosure, the rear cover assembly 60 further includes an electrochromic layer 66 disposed on a surface of the color-adjusting anti-shatter layer 65 facing away from the rear cover 61, with portions corresponding to the camera module 40 and the display component 10 being reserved. The electrochromic layer 66 is configured to adjust the color and transparency of the rear cover 61, thereby improving the visual appearance and aesthetics of the electronic device 1. It will be appreciated that the electrochromic layer 66 may be bonded and fixed to the surface of the color-adjusting anti-shatter layer 65 facing away from the rear cover 61 by any one of an optically clear adhesive layer, a glue layer, or a double-sided adhesive tape layer. The phrase "portions corresponding to the camera module 40 and the display component 10 being reserved" means that the electrochromic layer 66 does not cover the positions corresponding to the camera module 40 and the display component 10. For example, the electrochromic layer 66 may be hollowed out or provided with through holes of corresponding shapes and sizes at the positions corresponding to the camera module 40 and the display component 10, so that the positions corresponding to the camera module 40 and the display component 10 are exposed from the electrochromic layer 66.

In at least one embodiment of the present disclosure, the rear cover assembly 60 may further include an anti-glare layer 67 disposed on a surface of the electrochromic layer 66 facing away from the color-adjusting anti-shatter layer 65. The anti-glare layer 67 is configured to improve the viewing angle of the rear cover 61 and the display component 10, reduce interference from ambient light, and reduce reflection from the rear cover 61. It will be appreciated that the anti-glare layer 67 may be bonded and fixed to the surface of the electrochromic layer 66 facing away from the color-adjusting anti-shatter layer 65 by any one of an optically clear adhesive layer, a glue layer, or a double-sided adhesive tape layer.

In other embodiments of the present disclosure, in order to reduce the overall thickness of the rear cover assembly 60, the electrochromic layer 66 may be omitted, and the anti-glare layer 67 is disposed on the surface of the color-adjusting anti-shatter layer 65 facing away from the rear cover 61. Moreover, the anti-glare layer 67 may be bonded and fixed to the surface of the color-adjusting anti-shatter layer 65 facing away from the rear cover 61 by any one of an optically clear adhesive layer, a glue layer, or a double-sided adhesive tape layer.

In at least one embodiment of the present disclosure, the rear cover assembly 60 further includes an anti-fingerprint (AF) layer 68 disposed on a surface of the anti-glare layer 67 facing away from the electrochromic layer 66. The anti-fingerprint layer 68 is configured to protect the rear cover assembly 60 from external environmental erosion, and also to improve the appearance characteristics and visual effect of the rear cover assembly 60. The principle of the anti-fingerprint layer is to disperse the texture of fingerprints so that fingerprints on the rear cover assembly cannot be displayed, thereby providing a certain antibacterial effect. After anti-fingerprint coating treatment, the surface of an object exhibits good hydrophobicity and oleophobicity. Therefore, the anti-fingerprint layer can also reduce the adhesion of various stains, providing water and oil repellency, and any adhered stains can be easily removed. As it is a highly dense film layer, it can continue to function even after wiping with a thin gauze or the like. Moreover, the film layer does not peel off, so the appearance does not deteriorate. It will be appreciated that the anti-fingerprint layer 68 may be bonded and fixed to the surface of the anti-glare layer 67 facing away from the electrochromic layer 66 by any one of an optically clear adhesive layer, a glue layer, or a double-sided adhesive tape layer.

In at least one exemplary embodiment, the thickness of the anti-fingerprint layer 68 is 80 nm to 120 nm, for example, 80 nm, 82 nm, 85 nm, 88 nm, 90 nm, 95 nm, 98 nm, 100 nm, 105 nm, 108 nm, 110 nm, 115 nm, 118 nm, 120 nm, or other values, which is not specifically limited in the present disclosure.

It will be appreciated that in other embodiments of the present disclosure, the rear cover assembly 60 may further include other optical film layers or other film layers for enhancing performance. The optical film layers may include one or more of an infrared filtering layer, an ultraviolet filtering layer, an anti-reflection film, and a strengthening layer.

In at least one embodiment of the present disclosure, the rear cover 61 may further include a brightness enhancement region disposed on the second surface 612 of the rear cover 61 at a position corresponding to a flash of the camera module 40. By providing a plurality of concentric annular patterns or threaded patterns in the brightness enhancement region of the rear cover 61, the light from the flash can be utilized more efficiently, thereby improving the illumination brightness of the brightness enhancement region and thus enhancing the photographing effect of the camera module 40.

It will be appreciated that, in some embodiments, the electronic device 1 may have communication capabilities, i.e., it may establish communication with a network via 4G (fourth generation mobile communication technology standard), 5G (fifth generation mobile communication technology standard), 6G (sixth generation mobile communication technology standard), W-LAN (wireless local area network), or communication methods that may emerge in the future. For the sake of brevity, this is not further limited in the embodiments of the present disclosure.

In at least one exemplary embodiment, the electronic device 1 may further include a processor and a memory. The processor is electrically connected to the main display module 20, the camera module 40, and the display component 10, and is configured to control the main display module 20 and the display component 10 to display, and to control the camera module 40 to capture images. The memory is electrically connected to the processor, and the memory is configured to store program codes required for operation of the processor, to control display content of the main display module 20 and the display component 10, and the like.

In at least one exemplary embodiment, the memory may include a volatile memory, such as a random access memory (RAM). The memory may also include a non-volatile memory (NVM), such as a read-only memory (ROM), a flash memory (FM), a hard disk drive (HDD), or a solid-state drive (SSD). The memory may also include a combination of the above types of memories.

In at least one exemplary embodiment, the processor includes one or more general-purpose processors, where a general-purpose processor may be any type of device capable of processing electronic instructions, including a central processing unit (CPU), a microprocessor, a microcontroller, a main processor, a controller, and the like. The processor is configured to execute various types of digital storage instructions, such as software or firmware programs stored in the memory, which enable a computing device to provide a wide variety of services.

In summary, the electronic device 1 provided in the embodiments of the present disclosure includes a middle frame 51, a rear cover 61, and the above-described display component 10, where the display component 10 is disposed between the middle frame 51 and the rear cover 61. The display component 10 includes a plurality of light emitting units 11, each of the light emitting units 11 including a circuit substrate 111, an LED chip 112, and an encapsulant 114. The circuit substrate 111 includes a mounting surface 1111. The LED chip 112 is disposed on the mounting surface 1111 and is electrically connected to the circuit substrate 111. The encapsulant 114 is disposed on the mounting surface 1111, is disposed around the LED chip 112, and covers the LED chip 112, thereby encapsulating the LED chip 112 on the circuit substrate 111. Therefore, by respectively disposing the plurality of LED chips 112 on their respective corresponding circuit substrates 111 and electrically connecting them to the corresponding circuit substrates 111, the display component 10 of the present disclosure can achieve a flexible and customizable design of the arrangement of the LED chips 112. For example, the plurality of LED chips 112 can be arranged to form different patterns according to design requirements. Moreover, by mounting and fixing the LED chips 112 onto the corresponding circuit substrates 111, the display component 10 can increase the mounting reliability of the LED chips 112 and avoid risks such as loosening or detachment.

Furthermore, by disposing the first encapsulant 1141 to encapsulate the LED chip 112 on the circuit substrate 111, and by disposing the second encapsulant 1142 around the first encapsulant 1141, not only can the effective light-emitting area of the LED chip 112 be increased, but also optical crosstalk between adjacent LED chips 112, which may cause light interference between adjacent optical paths, can be prevented, thereby improving the appearance refinement and light effect of the display component 10.

It should be understood that the terms "first", "second", etc. are used for descriptive purposes only and shall not be construed as indicating or implying relative importance or implicitly indicating the number of technical features indicated. Thus, a feature defined as "first" or "second" may explicitly or implicitly include one or more of said features. In the description of the embodiments of the present disclosure, "plurality" means two or more, unless otherwise expressly and specifically defined.

In the description of this specification, reference to terms such as "one embodiment", "some embodiments", "exemplary embodiment", "example", "specific example", or "some examples" means that a specific feature, structure, material, or characteristic described in connection with the embodiment or example is included in at least one embodiment or example of the present disclosure. In this specification, the schematic representations of the above terms do not necessarily refer to the same embodiment or example. Moreover, the described specific features, structures, materials, or characteristics may be combined in any suitable manner in any one or more embodiments or examples.

It should be understood that the application of the present disclosure is not limited to the above examples. Those of ordinary skill in the art may make improvements or modifications based on the above description, and all such improvements and modifications shall fall within the scope of protection of the appended claims of the present disclosure. Those of ordinary skill in the art will appreciate that all or part of the methods for implementing the above embodiments, and equivalent variations made in accordance with the claims of the present disclosure, still fall within the scope encompassed by the present disclosure.

## Claims

1. A display component for an electronic device, wherein the display component comprises a plurality of light emitting units; each of the light emitting units comprises:
a circuit substrate comprising a mounting surface;
an LED chip disposed on the mounting surface and electrically connected to the circuit substrate; and
an encapsulant disposed on the mounting surface, and disposed around the LED chip and covering the LED chip, thereby encapsulating the LED chip on the circuit substrate.

2. The display component according to claim 1, wherein the display component further comprises a circuit board, and the circuit substrates of the plurality of light emitting units are connected to the circuit board; one or more of the LED chips are disposed on each of the circuit substrates; a gap is defined between each two adjacent circuit substrates; the plurality of the light emitting units are arranged in a matrix on the circuit board, so as to form the display component.

3. The display component according to claims 1 or 2, wherein in each of the plurality of light emitting units, the encapsulant comprises a first encapsulant and a second encapsulant; the first encapsulant is disposed on the circuit substrate and encapsulates the LED chip; the second encapsulant is disposed around the first encapsulant, and the second encapsulant and the circuit substrate cooperatively define a cavity, and the LED chip is disposed within the cavity.

4. The display component according to claim 3, wherein the second encapsulant is a closed frame formed by a dam wall; a wall thickness of the dam wall of the second encapsulant is greater than or equal to 0.035 mm and less than or equal to 0.15 mm; and optionally wherein
a shape of an orthographic projection of the second encapsulant onto the circuit substrate is a rectangular frame, and a side length of the rectangle is greater than or equal to 0.55 mm, and a minimum distance between any two adjacent ones of the second encapsulants is greater than or equal to 0.2 mm; or
a shape of an orthographic projection of the second encapsulant onto the circuit substrate is an annular frame, and an outer diameter of the annulus is greater than or equal to 0.55 mm, and a minimum distance between any two adjacent ones of the second encapsulants is greater than or equal to 0.2 mm.

5. The display component according to any one of claims 1 to 4, wherein the display component further comprises a lamp cover covering all of the light emitting units;
alternatively, the display component further includes a plurality of lamp covers, each lamp cover covering one or more of the light emitting units;
each lamp cover comprises an effect layer located in a light emission direction of the one or more of the light emitting units covered by the lamp cover; the effect layer is configured to transmit light emitted by the LED chips of the one or more of the light emitting units covered by the lamp cover and produce a predetermined display effect.

6. The display component according to claim 5, wherein:
an inner surface of each of the lamp covers has a plurality of light-transmitting regions, each of the plurality of light-transmitting regions corresponds to at least one of the LED chips; light emitted by each of the LED chips transmits through a corresponding light-transmitting region of the lamp cover to produce different light output effects; and/or
the effect layer of each of the lamp covers comprises one or more of a color filter film, a light-transmitting film having a predetermined transmittance, a textured film, a light-diffusing film, and a brightness enhancement film.

7. The display component according to claims 5 or 6, wherein in each of the plurality of light emitting units, the encapsulant comprises a first encapsulant and a second encapsulant, and the lamp cover is provided with a plurality of light-shielding portions in a direction parallel to the light emission direction of the plurality of light emitting units, and each of the light-shielding portions corresponds to a respective one of the second encapsulants and abuts against the corresponding second encapsulant.

8. The display component according to any one of the preceding claims, wherein the display component further comprises a plurality of driving circuits, wherein the same driving circuit controls one or more of the LED chips.

9. The display component according to any one of claims 5 to 7, wherein the display component further comprises at least one decorative sheet surrounding an outer edge of the at least one lamp cover.

10. The display component according to any one of the preceding claims, wherein the display component further comprises at least one pressure-sensitive button configured to be disposed on a rear cover or a frame of the electronic device, and the pressure-sensitive button is configured to turn the display component on or off.

11. An electronic device, wherein the electronic device comprises a middle frame, a rear cover, and a display component disposed between the middle frame and the rear cover; the display component comprises a plurality of light emitting units; each of the light emitting units comprises:
a circuit substrate comprising a mounting surface;
an LED chip disposed on the mounting surface and electrically connected to the circuit substrate; and
an encapsulant disposed on the mounting surface, and disposed around the LED chip and covering the LED chip, thereby encapsulating the LED chip on the circuit substrate.

12. The electronic device according to claim 11, wherein the electronic device further comprises a drive control unit electrically connected to the LED chips of the display component, and configured to control the display component to light up or present different display patterns according to a preset manner.

13. The electronic device according to claims 11 or 12, wherein the display component further comprises at least one lamp cover, each lamp cover covering one or more of the light emitting units; a surface of each of the at least one lamp cover facing away from the one or more of the light emitting units covered thereby abuts against the rear cover of the electronic device; alternatively, a side of each of the at least one lamp cover facing away from the one or more of the light emitting units covered thereby forms part of the rear cover of the electronic device.

14. A method of manufacturing a display component, for manufacturing a display component according to claim 1, wherein the manufacturing method comprises:
electrically connecting a plurality of LED chips to a circuit substrate;
forming an encapsulant layer on the circuit substrate, the encapsulant layer covering and encapsulating the LED chips onto the circuit substrate;
cutting the encapsulant layer to divide the encapsulant layer into a plurality of encapsulants, each of the plurality of encapsulants covering a respective one of the plurality of LED chips, so as to form a plurality of light emitting units; and
arranging the plurality of light emitting units in a matrix on a circuit board, and electrically connecting the circuit substrates of the plurality of light emitting units to the circuit board.

15. The method of manufacturing the display component according to claim 14, wherein the step of cutting the encapsulant comprises:
cutting a plurality of grooves in the encapsulant layer to divide the encapsulant layer into a plurality of first encapsulants, wherein each of the plurality of first encapsulants encapsulates a respective one of the plurality of LED chips;
filling the plurality of grooves with an encapsulant material such that the encapsulant material is disposed around the first encapsulants; and
cutting through the encapsulant material down to the circuit substrate to divide the encapsulant material into a plurality of second encapsulants, wherein each of the plurality of the second encapsulants is disposed around a respective one of the plurality of first encapsulants, so as to form each of the plurality of encapsulants covering a respective one of the plurality of LED chips.
